# EUROPÄISCHE PATENTANMELDUNG

(11) **EP 2 019 429 A1**
(43) Veröffentlichungstag der Anmeldung: **28.01.2009**
(21) Anmeldenummer: 08104712.8
(22) Anmeldetag: 11.07.2008
(51) Int. Cl.: H01L 25/07, H01L 23/538

(54) **Modul mit einem zwischen zwei Substraten, insbesondere DCB-Keramiksubstraten, elektrisch verbundenen elektronischen Bauelement und dessen Herstellungsverfahren**

(30) Priorität: 24.07.2007 DE 102007034491
(71) Anmelder: Siemens Aktiengesellschaft, 80333 München (DE)
(72) Erfinder: Kaltenbacher, Axel, 85737, Ismaning (DE); Weinke, Robert, 81825, München (DE); Kaspar, Michael, 85640, Putzbrunn (DE); Schimetta, Gernot, 81541, München (DE); Weidner, Karl, 81245, München (DE); Zapf, Jörg, 81927, München (DE)

(57) **Zusammenfassung**

Die vorliegende Erfindung betrifft ein Modul (1) mit mindestens einem ungehäusten elektronischen Bauelement (2) mit auf einer Oberseite und/oder Unterseite angeordneten Anschlussflächen (3) zur elektrischen Kontaktierung und zur Befestigung. Bei einer Verwendung einer Vielzahl von elektronischen Bauelementen (2) soll eine kostengünstige elektrische Kontaktierung bereitgestellt werden. Die elektronischen Bauelemente (2) sollen sehr kompakt geschaffen werden. Die vorliegende Erfindung zeichnet sich dadurch aus, dass mindestens ein Bauelement (2) zwischen zwei Substraten (5), insbesondere DCB-Keramiken derart positioniert ist, dass die Anschlussflächen (3) jeweils eine elektrische Kontaktierung und/oder Befestigung mit, diesen Anschlussflächen (3) gegenüber liegenden, elektrischen Leitern (7) und/oder Befestigungsflächen auf den Substraten (5) aufweisen. Zur Erzeugung hoher Isolationsfestigkeiten sind Distanzhalter (17) sowie eine elektrische Isolation mittels eines spritzgegossenen Kunststoffs (21) zwischen den Substraten, den elektronischen Bauelementen (2) und gegebenenfalls weiteren Metallkörpern (9) erzeugt. Die erzeugten Module (1) eigenen sich besonders vorteilhaft für ungehäuste elektronische Bauelemente (2) der Leistungselektronik mit Hochspannungen größer als 1000 V, da die erzeugte Wärme einfach und wirksam abgeführt werden kann.

## Beschreibung

Die Erfindung betrifft ein Modul gemäß dem Oberbegriff des Hauptanspruchs und ein entsprechendes Verfahren zur Herstellung gemäß dem Oberbegriff des Nebenanspruchs.

Herkömmlicherweise wird eine DCB-Keramik als Substrat verwendet, wobei elektronische Bauelemente mit Ihrer Rückseite flächig aufgelötet werden. "DCB" bedeutet "Direct Copper Bonding", wobei eine Kupferfolie auf eine Keramik aufgewalzt ist. Ein bekannter Hersteller derartiger Keramiken heißt "curamik". Eine Kontaktierung erfolgt mittels Dickdrahtbonden oder alternativ planar gemäß der WO 03030247, deren Inhalt hiermit ausdrücklich vollständig zur Offenbarung dieser Anmeldung gehört. Gemäß einem planaren Kontaktieren wird ein Dickdrahtbonden durch Laminieren einer Isolationsfolie, Öffnen von Kontaktfestern durch Laserablation und Erzeugung einer planaren Verbindung durch galvanisch abgeschiedene Metallisierung ersetzt.

Herkömmliche elektrische Kontaktierungen sind aufwändig, erfordern viel Platz, weisen ein induktives Verhalten auf, wobei die Stromtragfähigkeit gering ist. Ebenso sind eine gute Kühlung sowie eine hohe Zuverlässigkeit bei elektrischer und thermischer Zykelbeanspruchung aufwändig. Elektrische Zykelbeanspruchung bedeutet das abwechselnde Aussetzen unter eine niedrige elektrische Leistung und eine hohe elektrische Leistung mit einer bestimmten Anzahl von Lastwechseln. Thermische Zykelbeanspruchung bedeutet das abwechselnde Aussetzen unter eine niedrige Temperatur, beispielsweise - 40°C, und eine hohe Temperatur, beispielsweise +125°C, mit einer bestimmten Anzahl von Temperaturwechseln, beispielsweise 100 bis 1000 Zykeln.

Es ist Aufgabe der vorliegenden Erfindung bei mindestens einem ungehäusten elektronischen Bauelement, insbesondere ungehäusten Leistungsbauelement oder ungehäusten Leistungshalbleiterbauelement, an das insbesondere eine Hochspannung größer 1000 Volt anliegt , eine kostengünstige elektrische Kontaktierung bereit zu stellen. Dies betrifft insbesondere ungehäuste elektronische Bauelemente der Hochleistungselektronik, insbesondere IGBTs (Insulated Gate Bipolar Transistoren), Dioden und dergleichen. Es soll eine hohe Integrationsdichte und/oder niederinduktives Verhalten der Kontaktierung bereit gestellt sein. Des Weiteren sollen eine hohe Stromtragfähigkeit, eine wirksame Kühlung und eine hohe Zuverlässigkeit bei elektrischer und/oder thermischer Zykelbeanspruchung geschaffen sein.

Die Aufgabe wird durch ein Modul gemäß dem Hauptanspruch und ein Verfahren zur Herstellung eines Moduls gemäß dem Nebenanspruch gelöst.

Indem ungehäuste Bauelemente zwischen zwei Substraten, insbesondere DCB-Keramiksubstraten, fixiert und elektrisch kontaktiert werden, kann ein einfacher kostengünstiger und kompakter Modulaufbau geschaffen werden. Zwischenräume sind mittels eines gegossenen Kunststoffes als Isolationsmaterial derart befüllbar, dass trotz hoher Integrationsdichte, insbesondere bei Verwendung einer Mehrzahl von elektronischen Bauelementen, diese kostengünstig und vorteilhaft elektrisch kontaktiert und/oder befestigt werden können.

Beispielsweise wird auf ein mit Bauelementen bestücktes erstes, unteres Substrat, ein möglicherweise ebenfalls bestücktes zweites, oberes Substrat so positioniert aufgesetzt, dass elektronische Bauelemente in der Regel an ihren Vorder- und Rückseiten an den Substraten angrenzen. Im einfachsten Fall liegen die oberen und die unteren Anschlussflächen der Bauelemente jeweils in einer Ebene.

Durch derartige Module kann eine hohe Stromtragfähigkeit durch dicke Verbindungen aus elektrisch hoch leitfähigem Material sowie eine niederinduktive Kontaktierung von elektronischen Bauelementen bereitgestellt werden.

Gemäß einer weiteren vorteilhaften Ausgestaltung ist zwischen den beiden Substraten mindestens ein Metallkörper, insbesondere Kupferblock, für eine elektrische Funktion, beispielsweise Herstellung einer elektrischen Verbindung, und/oder Kühlung fixiert, wobei Flächen des Metallkörpers jeweils eine, insbesondere elektrische, Kontaktierung mit den Flächen des Metallkörpers gegenüber liegenden, elektrischen Leitern und/oder Befestigungsflächen auf den Substraten aufweisen. Die Metallkörper können Substratverbindungen erzeugen und/oder Bauelementhöhenunterschiede ausgleichen. Die Bereitstellung der Metallkörper erfolgt entsprechend der Bereitstellung der elektronischen Bauelemente.

Gemäß einer weiteren vorteilhaften Ausgestaltung sind die Zwischenräume zwischen den beiden Substraten und elektronischen Bauelementen beziehungsweise Metallkörpern mit einem elektrisch isolierenden Material ausgefüllt. Das heißt, es können freie Bereiche zwischen den beiden Substraten und Bauelementen beziehungsweise Metallkörpern durch einen Spritzgussprozess mit isolierendem Material gefüllt werden.

Gemäß einer weiteren vorteilhaften Ausgestaltung erfolgt eine elektrische Kontaktierung und/oder Befestigung der elektronischen Bauelemente und/oder Metallkörper mittels Lot, Laserschweißen und/oder Kleben. Die Kontaktierung mittels Löten schließt ebenso ein Reaktionslöten zu intermetallischen Phasen sein. Das Kleben kann leitend und/oder nicht leitend erfolgen.

Gemäß einer weiteren vorteilhaften Ausgestaltung des Verfahrens werden vor dem Kontaktieren kleiner Anschlussflächen, beispielsweise Gate-Anschlussflächen, auf diesen und/oder auf diesen gegenüber liegenden elektrischen Leitern und/oder Befestigungsflächen des gegenüberliegenden Substrats Bumps, insbesondere Lotbumps, Studbumps oder Leitkleberdepots ausgebildet. Studbumps sind insbesondere Kugeln aus Gold, Kupfer oder Aluminium, die mittels einfachem Drahtbonden erzeugt wurden, wobei nach dem Erzeugen der Bonddraht weitgehend derart entfernt wurde, dass weitere elektrische Ankontaktierungen ausgeführt werden können. Weitere kleinere Anschlusspads können beispielsweise Steuerkontakte sein. Bumps werden auf der Bauelementseite oder auf der Substratseite erzeugt. Die DCB-Keramiken weisen kupferhaltige Leiterbahnen, Leiter beziehungsweise Leadframes auf. Die Lot- oder Kleberkontakte können schon im Voraus auf der Substratseite aufgebracht worden sein.

Gemäß einer weiteren vorteilhaften Ausgestaltung ist zwischen einer kleinen Anschlussfläche und einem auf einem Substrat angeordneten elektrischen Leiter und/oder Befestigungsfläche eine Anschlussflächenvergrößerung in Form einer Nase oder Kontaktzunge, insbesondere auf dem elektrischen Leiter, ausgebildet. Zur leichteren Kontaktierung kleinerer Anschlusspads können die Nasen oder Kontaktzungen im DCB-Kupfer beispielsweise mittels Prägen oder Ätzen erzeugt sein.

Gemäß einer weiteren vorteilhaften Ausgestaltung ist zwischen einem Bauelement und einem Substrat ein, insbesondere Kupfer aufweisender, Distanzhalter zur Vergrößerung von Abständen zwischen Bauelementkanten und Substraten und/oder zur elektrischen Kontaktierung verschiedener Verdrahtungsebenen ausgebildet. Das heißt, durch aufgelötete Distanzhalter, insbesondere Kupfer aufweisende Distanzhalter, kann erreicht werden, dass Substrate und Chipkanten ausreichend weit voneinander entfernt sind, so dass hohe Isolationsfestigkeiten erzeugbar sind. Mittels der Distanzhalter können ebenso Verdrahtungsebenen miteinander kontaktiert werden. Das heißt, mittels additiv und/oder subtraktiv strukturierter Höcker können Bauelementeckenpotentiale wirksam isoliert werden.

Gemäß einer weiteren vorteilhaften Ausgestaltung ist auf mindestens einer der beiden dem Bauelement abgewandten Seiten der Substrate mindestens ein Kühlkörper zur Abfuhr von Wärme, insbesondere aus dem Zwischenraum zwischen den beiden Substraten geschaffen und insbesondere mittels Lot und/oder Kleber wärmeleitend fixiert. Das heißt zur besseren Wärmeabfuhr können Kühlkörper auf den freiliegenden Seiten der beiden Substrate angeordnet und wärmeleitend mittels Löten und/oder Kleben fixiert werden. Es ist auf eine einfache Weise eine doppelseitige Kühlung bereitstellbar.

Gemäß einer weiteren vorteilhaften Ausgestaltung weisen die Substrate verschiedene Dicken und/oder Materialien auf. Damit können die Substrate auf einfache Weise hinsichtlich ihrer Funktionen angepasst sein.

Gemäß einer weiteren vorteilhaften Ausgestaltung wird in dem mit elektrisch isolierendem Material ausgefüllten Zwischenraum mindestens ein Kanal zur Abfuhr von Wärme mittels eines Kühlmediums erzeugt. Auf diese Weise ist die Kühlleistung des Moduls zusätzlich vergrößert. In Ergänzung können zusätzlich Wärmesenken und/oder Heatpipes bereitgestellt sein. Das heißt, bei der Erzeugung des Zwischenraums mit isolierendem Material können ebenso Kanäle freigehalten werden, durch die ein Kühlmedium Wärme abführen kann.

Gemäß einer weiteren vorteilhaften Ausgestaltung sind elektrische Anschlüsse des Moduls nach außen mittels von elektrisch isolierendem Material freien Kontakten erzeugt. Das heißt, der elektrische Anschluss des Moduls nach außen erfolgt durch nicht umspritzte Kontakte.

Gemäß einer weiteren vorteilhaften Ausgestaltung ist das elektrisch isolierende Material ein hoch gefülltes Epoxy. Alternativ oder kumulativ weist das elektrisch isolierende Material einen an das Material mindestens eines Substrates angepassten thermischen Ausdehnungskoeffizienten auf. Der Spritzgussprozess zur Erzeugung des Raumes mit dem elektrisch isolierenden Material kann besonders vorteilhaft ein Transfermoldprozess sein.

Gemäß einer weiteren vorteilhaften Ausgestaltung weist das elektrisch isolierende Material einen an das Material mindestens eines Leiters, insbesondere Leadframes, auf mindestens einer Substratpatte angepassten thermischen Ausdehnungskoeffizienten auf. Mittels der Anpassung von Ausdehungskoeffizienten von Leadframe und Isolator kann eine hohe thermomechanische und elektrische Zykelfestigkeit geschaffen werden. Das heißt, alternativ zur vorstehenden Ausgestaltung kann der Ausdehnungskoeffizient des elektrisch isolierenden Vergussmaterials so gewählt werden, dass eine Verspannung aufgebaut wird, die die Lotschicht zwischen Bauelement und auf einem Substrat angeordneten Leitern, insbesondere Leadframes, mechanisch derart entlastet, dass eine hohe Zykelfestigkeit geschaffen wird.

Gemäß einer weiteren vorteilhaften Ausgestaltung liegen bei Verwendung einer Vielzahl von elektronischen Bauelementen diese bevorzugt in einer Ebene. Damit ist auf einfache Weise das Modul erzeugbar. Sind jedoch verschiedene Ebenen, beziehungsweise Verdrahtungsebenen, erzeugt, so können diese mittels Distanzhalter angeglichen werden, so dass auf diese Weise eine einfache Kontaktierung ausgeführt werden kann.

Die vorliegende Erfindung wird anhand von Ausführungsbeispielen in Verbindung mit den Figuren näher beschrieben. Es zeigen
- Figur 1: ein Ausführungsbeispiel eines erfindungsgemäßen Moduls;
- Figur 2: ein Ausführungsbeispiel eines Verfahrens zur Herstellung eines erfindungsgemäßen Moduls;
- Figur 3: ein weiteres Ausführungsbeispiel eines Verfahrens zur Herstellung eines erfindungsgemäßen Moduls;
- Figur 4: ein drittes Ausführungsbeispiel eines Verfahrens zur Herstellung eines erfindungsgemäßen Moduls;
- Figur 5: das Ausführungsbeispiel gemäß Figur 1 in einer Draufsicht.

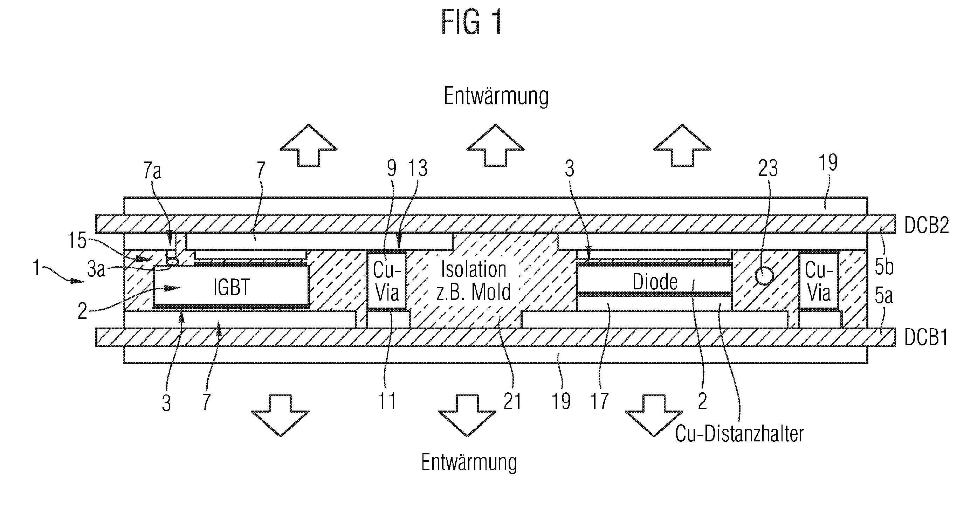

Figur 1 zeigt ein Ausführungsbeispiel eines erfindungsgemäßen Moduls 1. Das Modul 1 weist zwei elektronische Bauelemente 2 auf. Die elektronischen Bauelemente 2 sind ungehäust. Die elektronischen Bauelemente 2 sind ein Insulated Gate Bipolar Transistor und eine Diode. Beide elektronischen Bauelemente 2 weisen Anschlussflächen 3 auf der jeweiligen Oberseite und/oder Unterseite des Bauelements 2 auf. Diese Anschlussflächen 3 dienen der elektrischen Kontaktierung und/oder der Befestigung der elektronischen Bauelemente 2 mit zwei Substraten 5, zwischen denen die Bauelemente 2 positioniert sind. Besonders vorteilhaft werden als Substrate 5 DCB-("Direct Copper Bonding"-) Keramiken verwendet. Die Substrate 5 können unterschiedliche Dicken und/oder Materialien aufweisen. Gemäß dem Ausführungsbeispiel weisen die Substrate 5 gleiche Dicken und Materialien auf. Die Substrate 5 können die Form von Platten aufweisen. Andere Formen sind jedoch ebenso möglich, wie beispielsweise konkav oder konvex gebogene oder gekrümmte Flächen. Die Anschlussflächen 3 sind jeweils mit, den Anschlussflächen 3 gegenüber liegenden elektrischen Leitern 7 auf den Substraten 5 elektrisch angeschlossen und dabei befestigt. Es ist ebenso möglich, dass mittels der Anschlussflächen 3 lediglich eine elektrische Kontaktierung oder eine Befestigung bereitgestellt wird. Gemäß dem Ausführungsbeispiel sind zusätzlich zwischen den beiden Substraten zwei Metallkörper 9, insbesondere Kupferblöcke, positioniert. Blöcke können ebenso andere Metalle aufweisen. Die Metallkörper 9 können beispielsweise eine elektrische Leitung zwischen den beiden Substraten 5 und darauf angeordneten elektrischen Leitern 7 ausbilden. Zusätzlich können die Metallkörper 9 Kühlkanäle, Wärmesenken oder Heatpipes (Wärmeröhren) ausbilden. Zur elektrischen Kontaktierung und zur Befestigung sind die Flächen 11 der Metallkörper 9 jeweils mit, den Flächen 11 des Metallkörpers 9 gegenüber liegenden, elektrischen Leitern 7 auf den Substraten 5 elektrisch verbunden und befestigt. Die Anschlussflächen 3 der elektronischen Bauelemente 2 sind mittels eines Lots 13 mit den Leitern 7 auf den Substraten 5 elektrisch kontaktiert und daran befestigt. Alternativ können die Bauelemente 2 lasergeschweißt oder angeklebt sein. Zwischen einer kleinen Anschlussfläche 3a des Insulated Gate Bipolar Transistors und dem auf dem oberen Substrat 5b gegenüber liegend angeordneten elektrischen Leiter 7 ist eine Anschlussvergrößerung in Form einer Nase 7a erzeugt. Diese ist vorteilhaft auf dem dazugehörigen elektrischen Leiter 7 ausgebildet. Zusätzlich ist vor dem elektrischen Kontaktieren und Befestigen der kleinen Anschlussfläche 3a, die beispielsweise eine Gate-Anschlussfläche ist, auf dieser zur Vereinfachung des Kontaktierens und Befestigens ein Lotbump 15 erzeugt worden. Alternativ kann ein derartiger Lotbump 15 ein Studbump oder ein Leiterkleberdepot sein. Gemäß dem Ausführungsbeispiel ist zwischen der Diode 2 und dem unteren Substrat 5a ein Kupfer aufweisender Distanzhalter 17 ausgebildet. Dieser dient zur Vergrößerung des Abstands zwischen den unteren Kanten der Diode 2 und dem unteren Substrat 5a. Alternativ oder kumulativ kann der Distanzhalter 17 zur elektrischen Kontaktierung und/oder Befestigung von Bauelementen 2 verwendet werden, die nicht in einer Ebene liegen. Durch den Distanzhalter 17 können Kontakte in einer gemeinsamen Ebene der Bauelemente 2 ausgebildet werden. Auf diese Weise können gleiche Verdrahtungsebenen erzeugt werden. Gemäß dem Ausführungsbeispiel für ein Modul 1 ist auf beiden, den Bauelementen 2 abgewandten, Seiten der Substrate 5 ein Kühlkörper 19 zur Abfuhr von Wärme aufgebracht. Damit kann insbesondere Wärme aus dem Zwischenraum zwischen den beiden Substraten - unteres Substrat 5a und oberes Substrat 5b - abgeleitet werden. Die Kühlkörper 19 können mittels Lot und/oder mittels eines Klebers fixiert worden sein. Das Fixiermaterial ist besonders vorteilhaft Wärme leitend. Das hier dargestellte Modul 1 weist in den Zwischenräumen zwischen den beiden Substraten 5 und den elektronischen Bauelementen 2 und den Metallkörpern 9 ein elektrisch isolierendes Material, insbesondere ein Vergussmaterial, auf. Auf diese Weise ist eine besonders kompakte Bauweise des Moduls 1 bereitstellbar. Diese Isolation ist mit dem Bezugszeichen 21 gekennzeichnet. Gemäß einer vorteilhaften Ausgestaltung ist in dem mit elektrisch isolierendem Material 21 ausgefüllten Zwischenraum mindestens ein Kanal zur zusätzlichen Abfuhr von Wärme mittels eines Kühlmediums erzeugt. Ein derartiger Kanal ist mit dem Bezugszeichen 23 gekennzeichnet. Alternativ oder kumulativ kann ein Metallkörper 9 ebenso einen Kanal 23 zur Abfuhr von Wärme mittels eines Kühlmediums ausbilden. Dazu ist der Kanal 23 in dem Materialblock 9 geschaffen. Das Modul 1 kann zusätzlich von außerhalb des Moduls 1 elektrisch angeschlossen werden. Dazu weist das Modul 1 die auf den Substraten 5 angeordneten elektrischen Leiter 7 auf, die an den Kontaktstellen von dem elektrisch isolierenden Material 21 unbedeckt sind. Derartige Leiter 7 können alternativ Leadframes oder allgemein elektrische Kontakte sein. Gemäß Figur 1 ist das elektrisch isolierende Material 21 ein hoch gefülltes Epoxy. Beispielsweise kann das elektrisch isolierende Material 21 einen an das Material mindestens einer der Substrate 5 angepassten thermischen Ausdehnungskoeffizienten aufweisen. Bei Gleichheit der Ausdehungskoeffizienten werden mechanische Spannungen wirksam verhindert. Alternativ kann das elektrisch isolierende Material 21 einen an das Material mindestens eines auf mindestens einem Substrat 5 angeordneten Leiters 7 angepassten thermischen Ausdehnungskoeffizienten aufweisen. Bei Ungleichheit der Ausdehnungskoeffizienten kann eine Verspannung aufgebaut werden, die die Lotschicht 13 zwischen Bauelement 2 und Leiter 7 beziehungsweise Leadframe mechanisch entlastet, so dass eine hohe Zykelfestigkeit geschaffen wird. Gemäß Figur 1 ist ersichtlich, dass die obere Anschlussfläche des IGBT ursprünglich nicht in derselben Ebene wie die obere Anschlussfläche der Diode liegt. Durch Anbringen des Distanzhalters 17 an der Diode werden gemeinsame obere und untere Ebenen beziehungsweise gemeinsame Verdrahtungsebenen von IGBT und Diode erzeugt.

Alternativ kann das Modul 1 in zwei Einzelmodule mechanisch getrennt werden. Zudem kann eine Isolation der Potentiale der Bauelementecken mittels additiv oder subtraktiv strukturierter Höcker erzeugt sein.

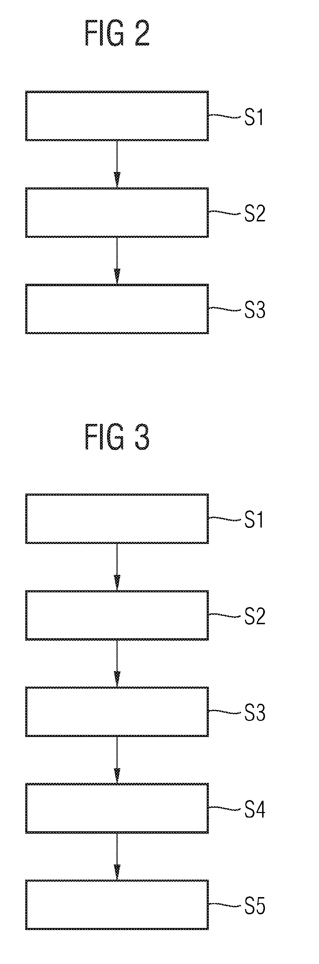

Figur 2 zeigt ein erstes Ausführungsbeispiel eines erfindungsgemäßen Verfahrens zur Herstellung eines erfindungsgemäßen Moduls 1. Das Ausführungsbeispiel gemäß Figur 1 kann als DCB²-Sandwich bezeichnet werden. Mit einem ersten Schritt S1 werden auf einem unteren DCB-Substrat 5a ein IGBT und eine Diode aufgesetzt und mittels Löten fixiert und elektrisch kontaktiert. Bei diesem Verfahren gemäß diesem Ausführungsbeispiel können beide Bauelemente 2 unterschiedliche Bauteilabmessungen aufweisen, wobei Höhenunterschiede des IGBTs und der Diode durch Distanzhalter 17 derart ausgeglichen werden können, dass dadurch erzeugte obere und untere Anschlussflächen 3 des IGBTs und der Diode jeweils in einer Ebene liegen. Mit einem Schritt S2 wird ein oberes DCB-Substrat 5b justiert aufgesetzt und mit den oberen Kontakten von IGBT und Diode durch einen weiteren Lötprozess verbunden. Die Kontaktierung des kleinen Gatepads 3a wird durch eine geprägte Kontaktzunge 7a des DCB-Kupfers oder einem vorab auf dem IGBT erzeugten Lotbump 15 erleichtert. An einigen Stellen können das untere DCB-Substrat 5a und das obere DCB-Substrat 5b mittels Metallkörper 9 durch Löten verbunden werden. Mit einem weiteren Schritt S3 werden die Freiräume zwischen den Substraten 5 beziehungsweise 5a und 5b, den Bauelementen 2 und den Metallkörpern 9 mittels Transfermolden mit einer Vergussmasse 21 beispielsweise einem Epoxy gefüllt, wobei zu Kühlzwecken Kanäle 23 in der Vergussmasse oder den Metallkörpern 9 freigelassen werden können.

Gemäß Figur 3 wird ein weiteres Verfahren zur Herstellung eines erfindungsgemäßen Moduls 1 vorgeschlagen. Gemäß einem ersten Schritt S1 werden auf ein unteres DCB-Substrat 5a elektronische Bauelemente 2 elektrisch kontaktiert und fixiert, deren obere und untere Anschlussflächen 3 jeweils in einer gemeinsamen Ebene liegen können. Liegen die entsprechenden Anschlussflächen 3 der elektronischen Bauelemente 2 nicht in einer Ebene können Distanzhalter 17 zum Ausgleich von Höhenunterschieden elektrisch kontaktiert und fixiert werden. Gemäß einem zweiten Schritt S2 werden auf dem zweiten, oberen DCB-Substrat 5b ebenso elektronische Bauelemente 2 auf der dem ersten, unteren DCB-Substrat 5a zugewandten Seite positioniert sowie elektrisch kontaktiert und fixiert. Gemäß einem dritten Schritt S3 wird das zweite, obere DCB-Substrat 5b auf das erste, untere DCB-Substrat 5a so positioniert aufgesetzt, dass die elektronischen Bauelemente 2, gegebenenfalls mit den Distanzhaltern 17, mit den noch freien Flächen jeweils an den gegenüberliegenden DCB-Substraten 5 anliegen.

Gemäß einem Schritt S4 werden, nach dem positionierten Aufeinandersetzen der Substrate 5a und 5b aufeinander, die den gegenüberliegenden DCB-Substraten 5 zugewandten Flächen der elektronischen Bauelemente 2 und/oder Distanzhalter 17, mit den gegenüberliegenden DCB-Substraten 5 elektrisch kontaktiert und fixiert. Mit einem weiteren Schritt S5 werden die Freiräume zwischen den Substraten 5a und 5b, den Bauelementen 2 mittels Transfermolden mit einer Vergussmasse 21 beispielsweise einem Epoxy gefüllt, wobei zu Kühlzwecken Kanäle 23 in der Vergussmasse oder den Metallkörpern 9 freigelassen werden können.

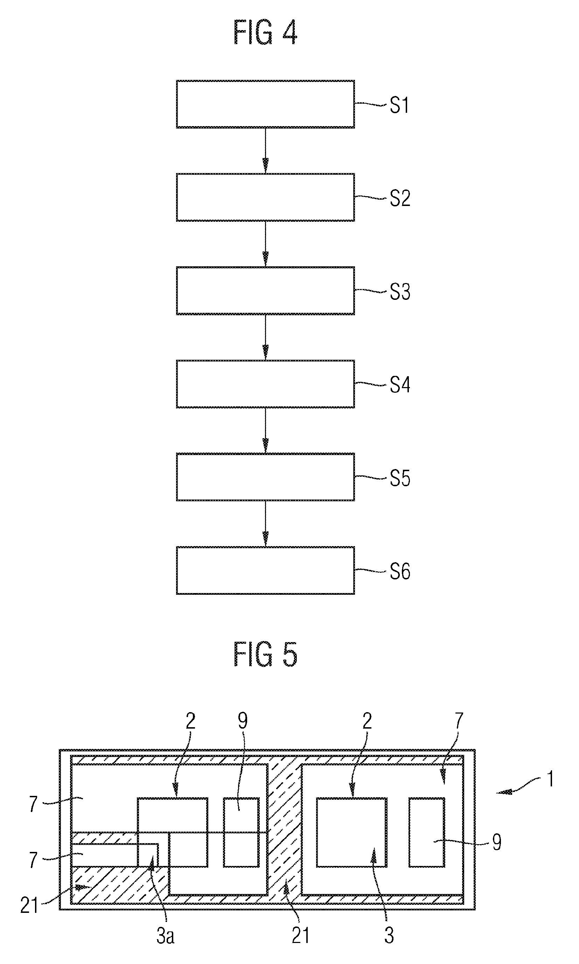

Figur 4 zeigt ein drittes Ausführungsbeispiel eines erfindungsgemäßen Verfahrens zur Herstellung eines erfindungsgemäßen Moduls 1. Mit einem ersten Schritt S1 wird ein erstes, unteres Substrat 5a mit Distanzhaltern 17 bestückt. Mit einem Schritt S2 werden elektronische Bauelemente 2 auf das Substrat 5a oder auf die Distanzhalter 17 gelötet. Mit einem Schritt S3 wird ein zweites, oberes Substrat 5b gegebenenfalls mit Distanzhaltern 17 bestückt und gegebenenfalls strukturiert. Mit einem Schritt S4 wird das zweite, obere Substrat 5b auf die elektronischen Bauelemente 2 des ersten, unteren Substrats 5a kontaktiert und befestigt, wobei die auf dem oberen Substrat 5a elektrisch kontaktierten und befestigten Distanzhalter 17 noch verbliebene Höhenunterschiede ausgleichen. Mit einem Schritt S5 wird der gesamte Aufbau zwischen den beiden Substraten 5a und 5b vermolded. Mit einem letzten Schritt S6 können Module 1 entsprechend den Funktionen der Module 1 vereinzelt werden.

Figur 5 zeigt das Modul 1 gemäß dem ersten Ausführungsbeispiel gemäß Figur 1 in einer Draufsicht. Die Bezugszeichen der Figur 5 entsprechen den Bezugszeichen der Figur 1. Bezugszeichen 2 bezeichnet die beiden elektronischen Bauelemente, nämlich den IGBT und die Diode. Bezugszeichen 3 bezeichnet die Anschlussflächen zur elektrischen Kontaktierung und Befestigung. 3a bezeichnet die Gate-Anschlussfläche des IGBT. Bezugszeichen 7 bezeichnet die auf den Substraten 5 angeordneten elektrischen Leiter, und zwar hier die Cu-Struktur auf der Keramik. Bezugszeichen 9 bezeichnet einen Metallkörper, der beispielsweise lediglich eine elektrische Leiterverbindung der beiden Substrate 5 erzeugt. Die elektrische Isolationsmasse ist mit Bezugszeichen 21 gekennzeichnet.

## Patentansprüche

1. Modul (1) mit mindestens einem ungehäusten elektronischen Bauelement (2), insbesondere ungehäusten Halbleiterbauelement oder ungehäusten Halbleiterleistungsbauelement, mit auf einer Oberseite und/oder Unterseite angeordneten Anschlussflächen (3) zur elektrischen Kontaktierung und/oder zur Befestigung,
**dadurch gekennzeichnet, dass**
das Bauelement (2) zwischen zwei Substraten (5), insbesondere DCB-Keramiksubstraten, derart positioniert ist, dass die Anschlussflächen (3) jeweils eine elektrische Kontaktierung und/oder Befestigung mit, den Anschlussflächen (3) gegenüberliegenden, elektrischen Leitern (7) und/oder Befestigungsflächen auf den Substraten (5) aufweisen.

2. Modul (1) nach Anspruch 1,
**dadurch gekennzeichnet, dass**
zwischen den beiden Substraten (5) mindestens ein Metallkörper (9), insbesondere Kupferblock, für eine elektrische Funktion und/oder Kühlung positioniert ist und Flächen (11) des Metallkörpers (9) jeweils eine elektrische Kontaktierung und/oder eine Befestigung mit, den Flächen (11) des Metallkörpers (9) gegenüberliegenden, elektrischen Leitern (7) und/oder Befestigungsflächen auf den Substraten (5) aufweisen.

3. Modul (1) nach Anspruch 1 oder 2,
**dadurch gekennzeichnet, dass**
Zwischenräume zwischen den beiden Substraten (5a, 5b) und dem elektronischen Bauelement (2) beziehungsweise dem Metallkörper (9) mit einem elektrisch isolierenden Material (21), insbesondere einem Spritz gegossenen Kunststoff, ausgefüllt sind.

4. Modul (1) nach Anspruch 1, 2 oder 3,
**dadurch gekennzeichnet, dass**
eine elektrische Kontaktierung und/oder Befestigung mittels eines Lots (13), Laserschweißen und/oder eines Klebers erzeugt wurde.

5. Modul (1) nach einem oder mehreren der vorangehenden Ansprüche 1 bis 4, **dadurch gekennzeichnet, dass** zwischen einer kleinen Anschlussfläche (3a) und einem auf einem Substrat (5) angeordneten elektrischen Leiter (7) und/oder Befestigungsfläche eine Anschlussflächenvergrößerung in Form einer Nase oder Kontaktzunge (7a), insbesondere auf dem elektrischen Leiter (7), ausgebildet ist.

6. Modul (1) nach einem oder mehreren der vorangehenden Ansprüche 1 bis 5, **dadurch gekennzeichnet, dass** zwischen einem Bauelement (2) und einem Substrat (5) ein, insbesondere Kupfer aufweisender, Distanzhalter (17) zur Vergrößerung von Abständen zwischen Bauelementkanten und Substraten (5) und/oder zur elektrischen Kontaktierung und/oder Befestigung ursprünglich verschiedener Verdrahtungsebenen ausgebildet ist.

7. Modul (1) nach einem oder mehreren der vorangehenden Ansprüche 1 bis 6, **dadurch gekennzeichnet, dass** auf mindestens einer der beiden dem Bauelement (2) abgewandten Seiten der Substrate (5) mindestens ein Kühlkörper (19) zur Abfuhr von Wärme, insbesondere aus dem Zwischenraum zwischen den beiden Substraten (5), geschaffen, und insbesondere mittels Lot und/oder Kleber Wärme leitend fixiert, ist.

8. Modul (1) nach einem oder mehreren der vorangehenden Ansprüche 1 bis 7, **dadurch gekennzeichnet, dass** die Substrate (5) verschiedene Dicken und/oder Materialien aufweisen.

9. Modul (1) nach einem oder mehreren der vorangehenden Ansprüche 3 bis 8, **dadurch gekennzeichnet, dass** in mit dem elektrisch isolierenden Material (21) ausgefüllten Zwischenraum, mindestens ein Kanal (23) zur Abfuhr von Wärme mittels eines Kühlmediums erzeugt ist.

10. Modul (1) nach einem oder mehreren der vorangehenden Ansprüche 3 bis 9, **dadurch gekennzeichnet, dass** elektrische Anschlüsse des Moduls (1) mittels nach außen geführter, von dem elektrisch isolierenden Material (21) freien Leitern (7), Leadframes (7) und/oder Kontakten bereitgestellt sind.

11. Modul (1) nach einem oder mehreren der vorangehenden Ansprüche 3 bis 10, **dadurch gekennzeichnet, dass** das elektrisch isolierende Material (21) hochgefülltes Epoxy ist und/oder einen an das Material mindestens eines Substrats (5) angepassten thermischen Ausdehnungskoeffizienten aufweist.

12. Modul (1) nach einem oder mehreren der vorangehenden Ansprüche 3 bis 11, **dadurch gekennzeichnet, dass** das elektrisch isolierende Material (21) einen an das Material mindestens eines, auf mindestens einem Substrat (5) angeordneten Leiters (7), insbesondere Leadframes (7), angepassten thermischen Ausdehnungskoeffizienten aufweist.

13. Modul (1) nach einem oder mehreren der vorangehenden Ansprüche 1 bis 12, **dadurch gekennzeichnet, dass** bei mehreren elektronischen Bauelementen (2), deren Anschlussflächen (3) jeweils in einer Ebene liegen, und/oder ursprünglich verschiedene Anschlussflächenebenen mittels Distanzhalter (17) in eine Ebene gebracht sind.

14. Verfahren zur Herstellung eines Moduls (1) nach einem oder mehreren der Ansprüche 1 bis 13, mit mindestens einem ungehäusten elektronischen Bauelement (2), insbesondere ungehäusten Halbleiterbauelement oder ungehäusten Halbleiterleistungsbauelement, mit auf einer Oberseite und/oder Unterseite angeordneten Anschlussflächen (3) zur elektrischen Kontaktierung und/oder zur Befestigung,
**gekennzeichnet durch**
- Bestücken mindestens einer von zwei Substraten (5), insbesondere DCB-Keramiksubstraten, mit mindestens einem Bauelement (2);
- Positionieren der beiden Substrate (5) derart aufeinander, dass das mindestens eine Bauelement (2) zwischen den beiden Substraten (5) positioniert ist; und
- elektrisches Kontaktieren und/oder Befestigen der Anschlussflächen (3) jeweils mit, den Anschlussflächen (3) gegenüberliegenden, elektrischen Leitern (7) und/oder Befestigungsflächen auf den Substraten (5).

15. Verfahren nach Anspruch 14,
**gekennzeichnet durch**
- zusätzliches Bestücken mindestens einer der zwei Substrate (5) mit mindestens einem Metallkörper (9), insbesondere Kupferblock, für eine elektrische Funktion und/oder Kühlung;
- zusätzliches Positionieren der beiden Substrate (5) derart aufeinander, dass der mindestens ein Metallkörper (9) zwischen den beiden Substraten (5) positioniert ist; und
- zusätzliches elektrisches Kontaktieren und/oder Befestigen von Flächen (11) des Metallkörpers (9) jeweils mit, den Flächen (11) gegenüberliegenden, elektrischen Leitern (7) und/oder Befestigungsflächen auf den Substraten (5).

16. Verfahren nach Anspruch 14 oder 15,
**gekennzeichnet durch**
Ausfüllen von Zwischenräumen zwischen den beiden Substraten (5a, 5b) und dem elektronischen Bauelement (2) beziehungsweise dem Metallkörper (9) mit einem elektrisch isolierenden Material (21), insbesondere mittels Spritzguss, insbesondere mittels eines Transfermoldprozesses.

17. Verfahren nach Anspruch 14, 15 oder 16,
**gekennzeichnet durch**
elektrisches Kontaktieren und/oder Befestigen mittels eines Lots, Laserschweißen und/oder eines, insbesondere leitenden, Klebers.

18. Verfahren nach einem oder mehreren der vorangehenden Ansprüche 14 bis 17,
**gekennzeichnet durch**
vor dem elektrischen Kontaktieren und/oder Befestigen kleiner elektrischer Anschlussflächen (3a), beispielsweise Gate-Anschlussflächen, auf diesen und/oder auf diesen gegenüberliegenden elektrischen Leitern (7) und/oder Befestigungsflächen des gegenüberliegenden Substrats (5) erfolgendes Ausbilden eines Bumps, insbesondere eines Lotbumps (15), eines Studbumps oder eines Leiterkleberdepots.

19. Verfahren nach einem oder mehreren der vorangehenden Ansprüche 14 bis 18, **gekennzeichnet durch** vor dem elektrischen Kontaktieren und/oder Befestigen kleiner Anschlussflächen (3a), beispielsweise Gate-Anschlussflächen, auf diesen und/oder auf diesen gegenüberliegenden elektrischen Leitern (7) und/oder Befestigungsflächen des gegenüberliegenden Substrats (5) erfolgendes Ausbilden einer Anschlussflächenvergrößerung in Form einer Nase oder Kontaktzunge (7a), beispielsweise mittels Prägen oder Ätzen.

20. Verfahren nach einem oder mehreren der Anspruch 14 bis 19, **gekennzeichnet durch** zwischen einem Bauelement (2) und einem Substrat (5) erfolgendes Ausbilden eines, insbesondere eines Kupfer aufweisenden, Distanzhalters (17) zur Vergrößerung von Abständen zwischen Bauelementkanten und Substraten und/oder zur Kontaktierung verschiedener Verdrahtungsebenen.

21. Verfahren nach einem oder mehreren der vorangehenden Ansprüche 14 bis 20, **gekennzeichnet durch**
- Ausbilden mindestens eines Kühlkörpers (19) zur Abfuhr von Wärme auf mindestens einer der beiden dem Bauelement (2) abgewandten Seiten der Substrate (5); und
- insbesondere mittels Lot und/oder Kleber Wärme leitendes Fixieren des Kühlkörpers (19).

22. Verfahren nach einem oder mehreren der vorangehenden Ansprüche 14 bis 21, **dadurch gekennzeichnet, dass** die Substrate (5) verschiedene Dicken und/oder Materialien aufweisen.

23. Verfahren nach Anspruch 16 bis 22, **gekennzeichnet durch** Erzeugen mindestens eines Kanals (23) zur Abfuhr von Wärme mittels eines Kühlmediums in dem mit elektrisch isolierendem Material (21) ausgefüllten Zwischenraum.

24. Verfahren nach einem oder mehreren der vorangehenden Ansprüche 16 bis 23, **gekennzeichnet durch** Bereitstellen von elektrischen Anschlüssen des Moduls (1), nach außen, mittels nicht von elektrisch isolierendem Material (21) umhüllten Leitern (7), Leadframes (7) und/oder Kontakten.

25. Verfahren nach einem oder mehreren der vorangehenden Ansprüche 16 bis 24, **dadurch gekennzeichnet, dass** das elektrisch isolierende Material (21) hochgefülltes Epoxy ist und/oder einen an das Material mindestens eines Substrats (5) angepassten thermischen Ausdehnungskoeffizienten aufweist.

26. Verfahren nach einem oder mehreren der vorangehenden Ansprüche 16 bis 25, **dadurch gekennzeichnet, dass** das elektrisch isolierende Material (21) einen an das Material mindestens eines auf mindestens einem Substrat (5) angeordneten Leiters (7), insbesondere Leadframes (7), angepassten thermischen Ausdehnungskoeffizienten aufweist.
